# FASCICULE DE BREVET EUROPEEN

(11) **EP 2 441 316 B1**
(45) Date de publication et mention de la délivrance du brevet: **06.03.2013**
(21) Numéro de dépôt: 10724843.7
(22) Date de dépôt: 09.06.2010
(51) Int. Cl.: H05K 3/34, B23K 3/06

(54) **CREUSET DE BRASAGE**
LÖTTIEGEL
BRAZING CRUCIBLE

(30) Priorité: 10.06.2009 FR 0902820
(43) Date de publication de la demande: 18.04.2012
(73) Titulaire: Robert Bosch GmbH, 70442 Stuttgart (DE)
(72) Inventeur: ELHAGE, Bassem, F-14340 Saint Loup de Fribois (FR)
(86) Numéro de dépôt international: PCT/EP2010/058086
(87) Numéro de publication internationale: WO 2010/142725

(56) Documents cités:
- DE-A1- 4 425 260
- DE-A1- 10 215 963
- US-A- 5 860 582

## Description

### Domaine de l'invention

La présente invention se rapporte à un creuset de brasage destiné à une installation de brasage partiel de composants électroniques traversants sur un circuit imprimé et à un procédé mettant en oeuvre un tel creuset.

Un circuit imprimé est un substrat rigide découpé perforé ou fraisé sur lequel se trouvent des composants électroniques montés en surface (appelés CMS) sur une et/ou sur ses deux faces et, des trous métallisés galvaniques qui sont utilisés pour l'insertion des pattes des composants traversants à braser ; ces derniers peuvent être en nombre quelconque.

Le circuit imprimé est composé de deux parties : une partie appelée « isolant » et une autre appelée « conducteur ».

La partie isolante appelée « prépreg » est composée d'une armature imprégnée de résine. Cette armature est souvent en fibres de verre et se présente sous la forme de tissus en trames, mais peut aussi être du quartz ou des fibres synthétiques commercialisées sous la marque Kevlar.

Le matériau de base d'un circuit imprimé double face est donc constitué d'un certain nombre de prépregs recouverts sur les deux faces extérieures de feuilles de cuivre.

Le matériau de base d'un circuit imprimé multicouches est, quant à lui, constitué de plusieurs prépregs entre lesquels s'intercalent des feuilles de cuivre, l'ensemble étant recouvert sur les deux faces extérieures de feuilles de cuivre.

La partie conductrice est composée d'une feuille de cuivre pur à 99,9 % ; elle est caractérisée par son épaisseur et ses propriétés physiques.

La feuille obtenue est ensuite découpée aux dimensions voulues et les perçages sont effectués en fonction du dessin de fabrication (lay-out) et sont métallisés (cuivrage) ; le lay-out est ensuite « dessiné », le vernis épargne déposé et enfin l'étamage ou dorure réalisé.

L'étamage ou laquage au vernis brasable ou dorure des circuits imprimés est une protection contre la corrosion.

Le brasage partiel aux creusets permet de réaliser une liaison mécanique et électrique entre des composants traversants, insérés manuellement ou automatiquement, et un circuit imprimé.

Cette liaison se fait à l'aide d'un alliage d'apport à l'état liquide, ayant une température de fusion inférieure à celle des pièces à réunir et mouillant les surfaces qui ne participent pas, par fusion, à la constitution du joint de brasage.

Les points importants du brasage sont la réaction métallurgique entre l'alliage d'apport et les pièces à braser et l'état de surface des pièces à braser.

Le brasage partiel aux creusets implique la mise en oeuvre d'une série d'étapes spécifiques dont la première consiste à positionner le circuit imprimé sur un support de façon à permettre son déplacement à travers la machine de brasage et l'insertion des pattes des composants à braser dans les trous métallisés, ce manuellement ou à l'aide d'un robot.

L'étape suivante consiste à transférer l'ensemble constitué par le support sur lequel a été inséré un ou plusieurs circuits imprimés portant les composants à braser à un poste de fluxage.

Le fluxage consiste à nettoyer et préparer chimiquement les surfaces à braser, en les soumettant à l'action d'un flux corrosif à base d'acide et d'alcool de façon à éliminer les oxydes qui ont pu s'y former et parallèlement à contribuer au bon mouillage de ces surfaces par l'alliage de brasage en favorisant et en accélérant la formation d'une mince couche de composé intermétallique entre l'alliage de brasage et le métal de base.

Lors de ce traitement, les composants à braser sont maintenus plaqués sur le circuit imprimé par des presseurs à ressorts et le flux de brasage est appliqué sur celui-ci à l'aide de pinceaux montés sur une matrice de fluxage spécifique, mobile en translation de façon à lui permettre d'immerger et de plonger dans le bain de flux.

Après l'étape de fluxage, le circuit imprimé et le support sont soumis à une étape de préchauffage (généralement un préchauffage par convection ou par résistances infrarouge).

A l'issue du préchauffage, la surface à braser est amenée à une température comprise en règle générale entre 95°C et 125°C.

Le préchauffage sert à évaporer l'alcool du flux déposé précédemment, à activer le flux et à amener le circuit imprimé et les composants qui y sont insérés à une température suffisamment élevée pour éviter les chocs thermiques au cours de l'étape de brasage.

A la fin de l'étape de préchauffage, le support est saisi par un bras manipulateur afin de le positionner au poste du brasage proprement dit.

Cette position doit être réalisée d'une manière très précise et répétitive dans un plan horizontal selon les axes x et y.

Le poste de brasage est composé d'une cuve, fermée sur le dessus à l'aide d'une plaque spécifique au circuit imprimé et d'un couvercle (généralement une vitre) dont le rôle est de maintenir étanche la cuve en dehors d'un cycle de brasage.

La cuve est remplie avec un alliage composé de 63 % d'étain et 37 % de plomb, dont le point de fusion est de 183°C.

Le bain d'alliage est maintenu à une température de l'ordre de 300°C à 325°C et se trouve sous atmosphère neutre grâce à un débit d'azote afin d'éviter son oxydation.

Le bain d'alliage renferme par ailleurs une matrice de brasage constituée d'une plaque portant une série de creusets de brasage dont la forme varie selon la géométrie des zones à braser sur le circuit imprimé.

La matrice de brasage est mobile en translation selon l'axe des z.

Pour permettre la réalisation du joint de brasage aux creusets, le couvercle protégeant le bain d'alliage s'ouvre pour laisser passer les creusets qui montent progressivement jusqu'à entrer en contact avec le dessous du circuit imprimé et sont maintenus quelques secondes dans cette configuration.

L'alliage contenu dans les creusets de brasage doit former sur le dessus une calotte convexe.

Lorsque cette calotte est en contact du circuit imprimé, l'alliage peut ainsi s'infiltrer par capillarité dans les trous métallisés, le long des pattes des composants à braser, et l'excès d'alliage provenant de la calotte s'écoule par des petits créneaux découpés à cet effet dans le bord du creuset.

Un bon écoulement de l'alliage, le long des creusets, suppose que l'alliage mouille correctement les surfaces des creusets.

Lorsque la durée de brasage est écoulée, les creusets descendent et retournent dans le bain de brasage, le couvercle se referme et le support est évacué.

Pendant cette opération, les composants à braser sont maintenus plaqués sur le circuit imprimé par des presseurs à ressorts de manière à les empêcher de bouger.

Le processus de brasage par capillarité est sujet à des dysfonctionnements pouvant avoir différentes origines, en particulier la température de l'alliage de brasage, qui, s'il est plus froid que le circuit imprimé et les pattes des composants électroniques à braser, ne peut pas remonter par capillarité dans les trous métallisés, de sorte qu'il est alors impossible d'obtenir un brasage correct.

La géométrie des creusets de brasage doit être choisie de façon à tenir compte de cet impératif, donc de façon à ce qu'ils puissent contenir suffisamment d'alliage de brasage pour apporter suffisamment de calories lorsqu'ils sont transférés à proximité des pattes des éléments électroniques à braser.

Toutefois cette géométrie ne peut pas être choisie de manière quelconque dans la mesure où il est nécessaire de tenir compte dans chaque cas particulier des zones dites taboues » c'est-à-dire des zones libres autour de chacune des pattes des composants électroniques à braser de façon en particulier à éviter tout risque de contact de l'alliage de brasage avec des composants électroniques voisins déjà fixés sur le circuit imprimé de nature à entraîner une détérioration de ces composants ou des courts circuits.

Le problème majeur auquel on se heurte lors du brasage partiel aux creusets est toutefois lié à la mouillabilité de la surface des creusets de brasage par l'alliage de brasage.

Pour permettre un brasage correct, il est en effet essentiel que l'alliage de brasage contenu dans un creuset de brasage forme en surface une calotte sphérique convexe de sorte qu'au contact avec la patte d'un composant électronique à braser, cet alliage puisse s'infiltrer par capillarité dans le trou métallisé entourant cette patte et remonter le long de celle-ci, et que l'alliage en excès puisse s'échapper par des créneaux prévus à cet effet sur le bord supérieur du creuset et s'écouler le long de ses parois externes pour retomber dans le bain d'alliage.

Il est donc essentiel que le ménisque de l'alliage de brasage contenu dans un creuset de brasage n'ait pas une forme concave et que l'alliage en excès ne risque pas de déborder et de s'étaler sur la surface de la platine de circuit imprimé à braser et les composants électroniques voisins qui pourraient être ainsi détériorés.

Or, cette exigence est conditionnée par la mouillabilité des creusets par l'alliage de brasage.

Les creusets utilisés sont constitués d'un acier doux de type E24 étamé chimiquement avec une couche d'étain homogène de l'ordre de 20 µm d'épaisseur, ceci afin d'optimiser le mouillage de l'alliage sur l'acier.

L'étamage chimique des creusets en acier permet la formation d'une fine couche intermétallique FexSny régulière de 1 µm d'épaisseur entre le fer et l'étain ; à l'état neuf, les creusets de brasage ont donc une mouillabilité satisfaisante.

Toutefois, dès que les creusets sont immergés dans le bain de brasage dont la température est de 300°C-325°C, la couche d'étain pur recouvrant les creusets neufs fond et disparaît totalement ; l'alliage de brasage se trouve alors immédiatement en contact avec une couche FeₓSn_{y} de 20 µm d'épaisseur et l'interface acier / étain devient irrégulière.

Cette couche est mouillable lorsque les creusets sont neufs mais, au cours de leur utilisation, cette couche s'épaissit et devient irrégulière à cause de la diffusion de l'étain de brasure dans l'acier et de l'apparition en surface des creusets de couches d'oxyde, ce qui rend ces surfaces passives et par conséquent leur fait perdre leur caractère mouillable.

Pour éviter le vieillissement des creusets, il est indispensable d'effectuer de fréquents nettoyages.

Le but de ce nettoyage est de supprimer les impuretés en surfaces des creusets et de ralentir le grossissement de la couche intermétallique FeₓSn_{y}.

Cette opération de nettoyage préventif qui est effectuée manuellement et à l'aide de brosses est particulièrement incommode du fait de la petite taille des creusets et de la présence d'angles morts auxquels il est difficile d'avoir accès et est en outre dangereuse dans la mesure où elle doit être mise en oeuvre en zone chaude, ce qui oblige le personnel à prendre des précautions spécifiques et à porter des moyens de protection tels que casque, visière...

### Etat de la technique

Les creusets de brasage utilisés pour la mise en oeuvre du procédé de brasage partiel aux creusets de platines de circuit imprimé sont classiquement de forme cylindrique.

Un creuset de brasage selon la préambule de la revendication 1 est divulgué par DE 4425260 A1.

Pour une installation fonctionnant 24 heures sur 24, de tels creusets doivent faire l'objet d'un nettoyage préventif immobilisant l'installation pendant environ 15 mn, six fois par jour.

De plus les creusets doivent être remplacés tous les mois et demi.

Ces mesures préventives lourdes ne permettent toutefois pas de satisfaire aux exigences de qualité recherchées qui sont de plus en plus sévères et on observe toujours un taux très élevé de défauts de brasage et en particulier de défauts de brasage critiques tels que points non brasés, problèmes de remontées d'alliage de brasage dans les trous métallisés, débordements d'alliage de brasage sur la face supérieure de la platine de circuit imprimé et sur les composants électroniques voisins.

### But de l'invention

La présente invention a pour objet de remédier à ces inconvénients.

Or, on s'est rendu compte conformément à l'invention que la forme des creusets de brasage influe fortement sur la qualité du brasage et en particulier sur l'efficacité de leur nettoyage préventif et de nombreux essais ont par suite été réalisés dans le but de trouver la forme optimale.

### Exposé et avantages de l'invention

Dans ce contexte, la présente invention propose un creuset de brasage destiné à la mise en oeuvre d'un procédé de brasage partiel aux creusets de circuits imprimés qui comporte au moins une paroi verticale plane, le creuset est en forme de prisme droit et caractérisé en ce que la base du prisme est hexagonale.

Selon une autre caractéristique de l'invention, le creuset est caractérisé en ce que la base du prisme est un hexagone régulier ou en d'autres termes le creuset est en forme de nid d'abeilles.

On a en effet pu constater que, de manière surprenante, les creusets en forme de nids d'abeilles permettent :
- de diminuer de 65 % le taux de défaut de brasage partiel,
- d'améliorer la satisfaction des clients,
- d'améliorer l'efficacité du nettoyage préventif des creusets et par conséquent la stabilité de la mouillabilité des creusets par l'alliage de brasage,
- de diviser par deux la fréquence de nettoyage préventif des creusets, ce qui pour une installation fonctionnant 24 heures sur 24 entraîne un gain de disponibilité de 45 mn par jour,
- de ne remplacer les creusets que tous les trois mois.

En corollaire, la sécurité du personnel chargé de la mise en oeuvre du procédé est ainsi notablement améliorée.

### Dessins

Les caractéristiques du creuset de brasage qui fait l'objet de l'invention seront décrites plus précisément en se référant aux dessins non limitatifs annexés dans lesquels :
- la figure 1 représente un circuit imprimé,
- la figure 2 est une vue schématique illustrant l'étape de brasage,
- les figures 3a, 3b et 3c sont des schémas respectivement illustratifs d'un exemple de brasage correct et de deux exemples de brasage défectueux,
- la figure 4 représente un creuset de brasage conforme à l'invention.

### Description d'un mode de réalisation de l'invention

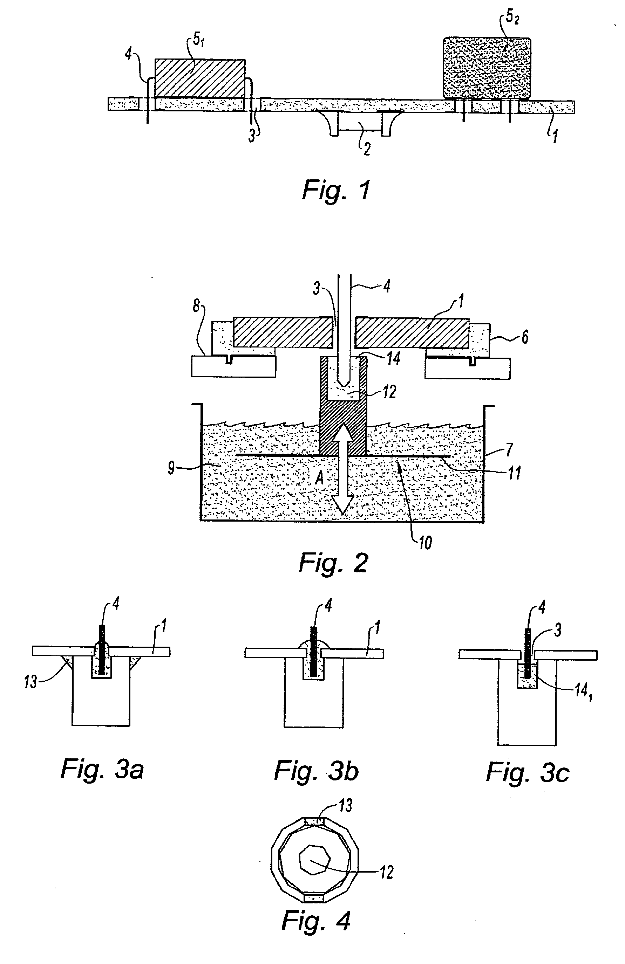

Selon la figure 1, le circuit imprimé 1 porte un composant électronique 2 déjà fixé sur sa face inférieure et est percé de trous métallisés 3 dans lesquels sont introduites les pattes 4 de deux composants à braser 5₁, 5₂ positionnés sur sa face supérieure.

Selon la figure 2, le circuit imprimé 1 est schématisé par une seule patte 4 et est représenté en position de brasage.

Ce circuit imprimé 1 est mis en place sur un support 6 et a subi préalablement les étapes de fluxage et de préchauffage.

La zone de brasage qui est elle aussi représentée schématiquement est composée d'une cuve 7 fermée sur le dessus à l'aide d'une plaque spécifique 8 et d'un couvercle dont le rôle est de maintenir étanche la cuve en dehors d'un cycle de brasage.

La cuve 7 est remplie avec un alliage de brasage 9 composé de 63 % d'étain et 37 % de plomb, maintenu à une température de l'ordre de 300°C à 325°C sous atmosphère neutre.

La cuve 7 renferme par ailleurs une matrice de brasage 10 constituée d'une plaque d'appui 11 portant une série de creusets de brasage 12 dont un seul est représenté.

Les creusets de brasage 12 sont répartis sur la plaque d'appui 11 selon une géométrie correspondant à celle des zones à braser sur le circuit imprimé 1 de sorte qu'un creuset de brasage 12 soit situé au droit de chacune des pattes 4 des composants 5₁, 5₂ devant être brasés (figure 1).

Selon la figure 4, les creusets de brasage 12 sont en forme de prismes droits à base hexagonale, c'est-à-dire en forme de nids d'abeilles et sont équipés au niveau de leur bord supérieur de deux créneaux 13 qui ont une hauteur d'environ 0,3 mm et ont pour fonction de permettre l'évacuation de l'alliage de brasage en excès.

Selon la figure 2, la matrice de brasage 10 est mobile en translation selon l'axe des z comme représenté schématiquement par la double flèche A.

Les creusets de brasage peuvent ainsi se déplacer verticalement entre une position basse non représentée dans laquelle ils plongent dans le bain d'alliage de brasage 9 de façon à pouvoir se remplir de cet alliage et une position haute représentée sur la figure 2 dans laquelle la calotte supérieure 14 de l'alliage qui y est contenu vient en contact avec le dessous du circuit imprimé et la patte 4 associée.

Selon les figures 2 et 3a, l'alliage de brasage 9 dont le dessus a une calotte convexe, contenu dans les creusets 12 s'infiltre alors par capillarité dans les trous métallisés 3 le long des pattes 4 des composants électroniques 5₁, 5₂ devant être brasés et remonte le long de ces pattes.

Selon la figure 3a, l'alliage de brasage en excès provenant de la calotte s'échappe par les créneaux 13 situés sur le bord supérieur des creusets 12 et s'écoule le long des parois externes de ces creusets avant de retomber dans le bain d'alliage 9.

L'obtention d'un tel brasage correct implique une bonne mouillabilité des surfaces des creusets 12 par l'alliage de brasage et la présence à la partie supérieure de cet alliage d'une calotte sphérique convexe 14.

En effet et comme représenté sur la figure 3b, dans le cas d'un mauvais mouillage des creusets de brasage 12, l'alliage en excès ne peut pas s'échapper par les créneaux 13, mais déborde et s'étale sur la surface supérieure du circuit imprimé 1 où il risque alors de détériorer les composants électroniques voisins et de générer ainsi des défauts de brasage.

De plus, et comme représenté sur la figure 3c, en présence d'une calotte sphérique concave 14, l'alliage de brasage ne peut pas complètement s'infiltrer par capillarité dans les trous métallisés 3 le long des pattes 4 des composants électroniques 5₁, 5₂ devant être brasés et la connexion entre la patte du composant et le circuit imprimé est défectueuse.

### NOMENCLATURE

- 1: Circuit imprimé
- 2: Composant électronique
- 3: Trous métallisés
- 4: Pattes
- 5₁, 5₂: Composants à braser
- 6: Support
- 7: Cuve d'alliage
- 8: Couvercle + plaque spécifique
- 9: Alliage de brasage
- 10: Matrice de brasage
- 11: Plaque d'appui
- 12: Creusets de brasage
- 13: Créneaux
- 14: Calotte sphérique convexe
- 14₁: Calotte sphérique concave

## Revendications

1. Creuset de brasage (12) destiné à une installation de brasage partiel de composants électroniques traversants sur un circuit imprimé qui **caractérisé en ce que** le prisme droit est comporte au moins une paroi verticale plane de manière à former un prisme droit de base hexagonale.

2. Creuset selon la revendication 1,
**caractérisé en ce que**
la base du prisme est un hexagone régulier ou en d'autres termes le creuset est en forme de nid d'abeilles.

3. Creuset selon la revendication 1 ou 2 **caractérisé en ce qu'**il comporte un créneau (13) sur le bord supérieur de ladite paroi verticale.

4. Creuset selon les revendications 2 et 3 **caractérisé en ce qu'**il comporte deux créneaux (13) situés sur deux parois en vis-à-vis dudit creuset.

5. Procédé de brasage **caractérisé en ce qu'**il comporte une étape consistant à remplir au moins partiellement un creuset selon l'une quelconque des revendications précédentes avec un alliage métallique et une étape consistant à plonger au moins une patte (4) d'un composant électrique ou électronique dans ledit creuset.

## Claims

1. Brazing crucible (12) designed for an installation for the partial brazing of electronic through-components on a printed circuit which comprises at least one flat vertical wall so as to form a totally reflecting prism, **characterized in that** the totally reflecting prism has a hexagonal base.

2. Crucible according to Claim 1, **characterized in that** the base of the prism is a regular hexagon or in other words the crucible is in the form of a honeycomb.

3. Crucible according to Claim 1 or 2, **characterized in that** it comprises a slot (13) on the top edge of the said vertical wall.

4. Crucible according to Claims 2 and 3, **characterized in that** it comprises two slots (13) situated on two opposite walls of the said crucible.

5. Brazing process, **characterized in that** it comprises a step consisting in at least partially filling a crucible according to any one of the preceding claims with a metal alloy and a step consisting in immersing at least one pin (4) of an electrical or electronic component in the said crucible.

## Patentansprüche

1. Löttiegel (12), der für eine Anlage zum teilweisen Löten von durchgehenden elektronischen Bauteilen auf eine Leiterplatte bestimmt ist, der mindestens eine ebene senkrechte Wand aufweist, um ein gerades Prisma zu formen, **dadurch gekennzeichnet, dass** das gerade Prisma eine sechseckige Grundfläche hat.

2. Tiegel nach Anspruch 1, **dadurch gekennzeichnet, dass** die Grundfläche des Prismas ein gleichmäßiges Sechseck ist, oder in anderen Worten der Tiegel die Form einer Bienenwabe hat.

3. Tiegel nach Anspruch 1 oder 2, **dadurch gekennzeichnet, dass** er eine Lücke (13) am oberen Rand der senkrechten Wand aufweist.

4. Tiegel nach den Ansprüchen 2 und 3, **dadurch gekennzeichnet, dass** er zwei Lücken (13) aufweist, die sich auf zwei einander gegenüberliegenden Wänden des Tiegels befinden.

5. Lötverfahren, **dadurch gekennzeichnet, dass** es einen Schritt, der darin besteht, einen Tiegel nach einem der vorhergehenden Ansprüche zumindest teilweise mit einer Metalllegierung zu füllen, und einen Schritt aufweist, der darin besteht, mindestens eine Lasche (4) eines elektrischen oder elektronischen Bauteils in den Tiegel zu tauchen.
